Europäisches Patentamt

European Patent Office

Office européen des brevets

(19)

(11) Veröffentlichungsnummer: **0 273 203 B1**

(12) **EUROPÄISCHE PATENTSCHRIFT**

(45) Veröffentlichungstag der Patentschrift: 14.08.91

(51) Int. Cl.⁵: **H03B 21/02**

(21) Anmeldenummer: 87117428.0

(22) Anmeldetag: 26.11.87

(54) **Frequenzsynthetisierer.**

(30) Priorität: 18.12.86 CH 5040/86

(43) Veröffentlichungstag der Anmeldung:
06.07.88 Patentblatt 88/27

(45) Bekanntmachung des Hinweises auf die
Patenterteilung:
14.08.91 Patentblatt 91/33

(84) Benannte Vertragsstaaten:
**CH DE FR GB IT LI NL SE**

(56) Entgegenhaltungen:
**FR-A- 2 268 391**
**US-A- 3 696 306**

**COLLOQUE INTERNATIONAL SUR LE RADAR,
Paris, 4.-8. Dezember 1978, Seiten 507-519,
J.J. BONNIER: "Synthétiseurs faible bruit
pour radars agiles"**

**IEEE TRANSACTIONS ON MICROWAVE
THEORY AND TECHNIQUES, Band MTT-30,
Nr. 5, Mai 1982, Seiten 686-693, IEEE, New
York, US; A.J. BUDREAU et al.: "A review of
SAW-based direct frequency synthesizers"**

(73) Patentinhaber: **SIEMENS-ALBIS AKTIENGE-
SELLSCHAFT
PV/Patente und Verträge Postfach
CH-8047 Zürich(CH)**

(72) Erfinder: **Fognini, Bruno
Am Suteracher 3
CH-8048 Zürich(CH)**

## Beschreibung

Die vorliegende Erfindung betrifft einen Frequenzsynthetisierer nach dem Oberbegriff des Patentanspruches 1.

Aus "IEEE Transactions on Microwave Theory and Techniques", Vol. MTT-30, No. 5, Mai 1982, S. 686-693, insbesondere Fig. 9, ist eine Anordnung zur Frequenzsynthese bekannt, bei der verschiedene, von einem Hauptoszillator abgeleitete Frequenzen miteinander kombiniert werden. Zu diesem Zweck ist eine Anzahl hintereinandergeschalteter Mischstufen vorgesehen, die je einen Mischer mit einem vorgeschalteten Frequenzteiler benutzen, um zwei von diesen Frequenzen wahlweise zu kombinieren, indem das Ausgangssignal des Mischers jeweils zur nächsten Stufe weitergeleitet wird. Damit können Ausgangssignale mit ausgezeichneter Kurz- und Langzeitstabilität geliefert werden, die zudem eine hohe Frequenzumschaltungsgeschwindigkeit aufweisen.

Eine solche Anordnung erweist sich jedoch als nachteilig im Hinblick auf die benötigte Umschalteinrichtung, die schon bei einer relativ kleinen Anzahl Mischstufen sehr aufwendig ist.

Ferner ist aus US-A-3,696,306 ein phasenkohärenter Frequenzsynthetisierer bekannt, der drei seriell betriebene PLL-Schaltungen aufweist. PLL-Schaltungen werden oft als Frequenzumwandler eingesetzt und haben bekanntlich den zusätzlichen Vorteil, dass sie mit Hilfe externer Signale gesteuert werden können, um Signale gegebener Frequenzen zu erzeugen. Derartige Schaltungen, die z.B. aus Colloque International Sur Le Radar, Paris, 4. - 8. Dezember 1978, Seiten 507 - 509, J. J. Bonnier: "Synthétiseurs faible bruit pour radars agiles" bekannt sind, weisen jedoch relativ hohe Umschaltzeiten auf. Durch das serielle Zusammenschalten von mehreren PLL-Schaltungen gemäss US-A-3,696,306 ergeben sich Umschaltzeiten, die für verschiedene Anwendungen, so z.B. in frequenz-agilen Radarsystemen, nicht mehr zulässig sind.

Der Erfindung liegt daher die Aufgabe zugrunde, eine solche Anordnung derart zu verbessern, dass sie auch bei einer relativ grossen Anzahl abgeleiteter Frequenzen mit einer relativ wenig aufwendigen Umschalteinrichtung auskommt. Ferner sollen die für Frequenzwechsel notwendigen Umschaltzeilen sehr kurz sein.

Der Erfindung liegt daher die Aufgabe zugrunde, eine solche Anordnung derart zu verbessern, dass sie auch bei einer relativ grossen Anzahl abgeleiteter Frequenzen mit einer relativ wenig aufwendigen Umschalteinrichtung auskommt.

Diese Aufgabe wird durch die im kennzeichnenden Teil des Patentanspruches 1 angegebenen Massnahmen gelöst. Vorteilhafte Ausgestaltungen der Erfindung sind in weiteren Ansprüchen angegeben.

Die Erfindung wird nachfolgend anhand einer Zeichnung beispielsweise näher erörtert. Es zeigt:

Fig. 1     das Blockschaltbild eines Frequenzsynthetisierers nach der Erfindung,

Fig. 2     das Blockschaltbild einer ersten PLL-Schaltung zu einem solchen Frequenzsynthetisierer,

Fig. 3     das Blockschaltbild einer weiteren PLL-Schaltung zu diesem Frequenzsynthetisierer.

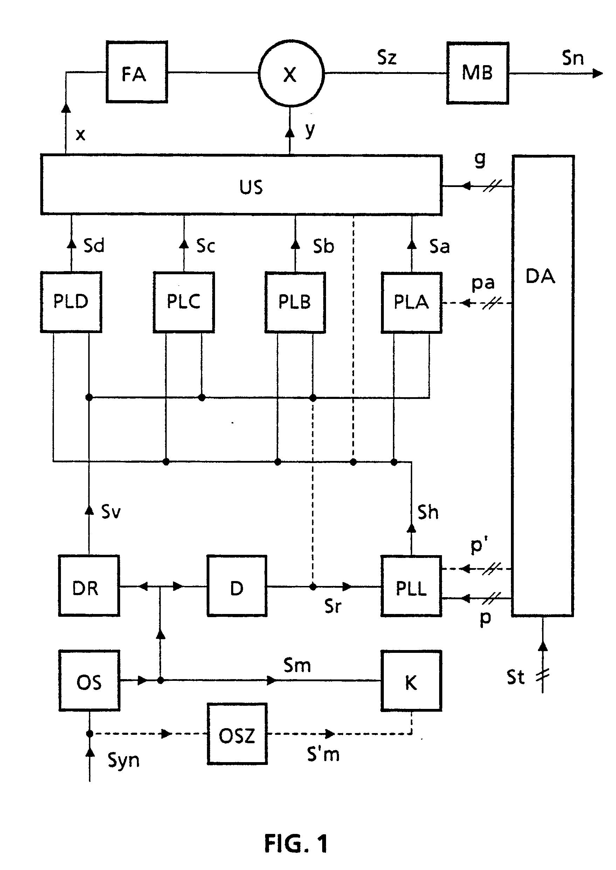

Der Frequenzsynthetisierer nach Fig. 1 weist eine Umschalteinrichtung US auf, die eingangsseitig mit je einem Signal Sa, Sb, Sc und Sd beaufschlagt wird und ausgangsseitig zwei Signale x und y liefert. Das Signal x wird über einen Frequenzumwandler FA dem ersten Eingang eines Mischers X zugeführt, dessen zweiter Eingang mit dem Signal y beaufschlagt ist. Das Ausgangssignal Sz des Mischers X wird einem weiteren Frequenzumwandler MB zugeführt, der das Nutzsignal Sn liefert. Die Signale Sa, Sb, Sc und Sd werden je einer PLL-Schaltung PLA, PLB, PLC bzw. PLD entnommen, deren Referenzsignaleingänge gemeinsam mit einem Signal Sv und deren Mischereingänge gemeinsam mit dem Ausgangssignal Sh einer weiteren PLL-Schaltung PLL beaufschlagt werden. Der Frequenzsynthetisierer umfasst zudem eine digitale Ansteuerung DA und einen Oszillator OS, der gegebenenfalls mit Hilfe eines externen Signals Syn synchronisierbar ist.

Das Ausgangssignal Sm des Oszillators OS wird einerseits über einen fakultativen Frequenzumwandler K dem Mischereingang der Schaltung PLL und andererseits dem Eingang weiterer Frequenzumwandler DR und D zugeführt, von denen der erste das Signal Sv und der zweite ein Ausgangssignal Sr liefert, mit dem auch die Schaltung PLL beaufschlagt wird. Die Ansteuerung DA liefert digitale Signale g und p zur Steuerung der Umschalteinrichtung US bzw. der Schaltung PLL. Die Ansteuerung DA selbst wird mittels externer Steuersignale St bedient.

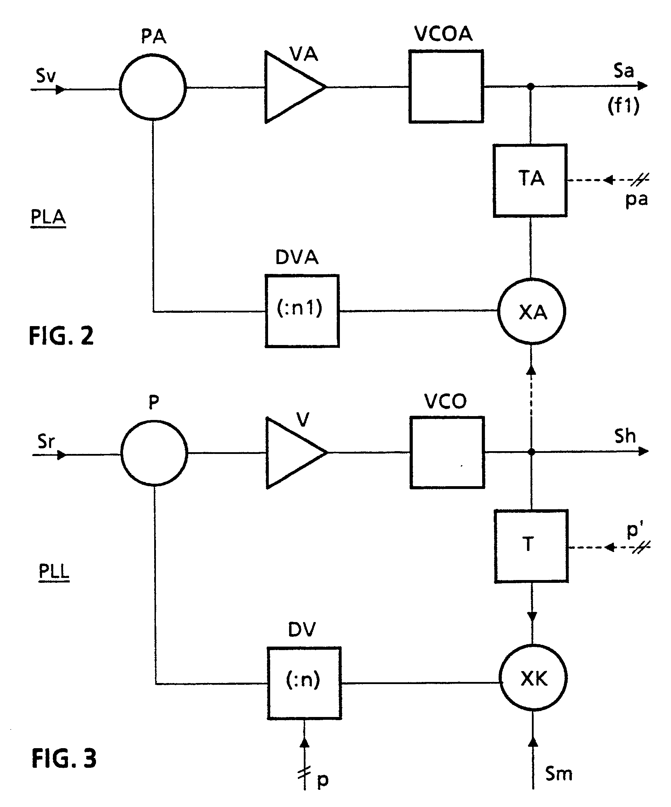

Die Schaltung PL1 nach Fig. 2 weist einen eingangsseitig mit dem Signal Sv beaufschlagten Phasenvergleicher PA auf, dessen Ausgang über die Reihenschaltung eines Regelverstärkers VA, eines spannungsgesteuerten Oszillators VCOA und eines fakultativen Frequenzumwandlers TA mit dem ersten Eingang Mischers XA verbunden ist, wobei zwischen den Steuereingang des Phasenvergleichers P und den Ausgang des Mischers XA ein weiterer Frequenzumwandler DVA eingefügt ist, der vorzugsweise als Frequenzteiler mit einem Teilungsfaktor $n1$ arbeitet. Der zweite Eingang des Mischers XA ist dem Signal Sh beaufschlagt. Das Ausgangssignal Sa der Schaltung PLA wird dem Ausgang des Oszillators VCOA entnommen. Die Systemteile PLB, PLC und PLD und gegebenenfalls weitere in Fig.1 nicht dargestellte Elemente sind der Schaltung PLA nach Fig. 2 ähnlich und weisen vorzugsweise Teilungsfaktoren n2, n3, n4, ... auf.

Die Schaltung PLL nach Fig. 3 umfasst ebenfalls einen Phasenvergleicher P, einen Regelverstärker V, einen spannungsgesteuerten Oszillator VCO, einen fakultativen Frequenzumwandler T, einen Mischer XK und einen weiteren Frequenzumwandler DV, die in Funktion und Aufbau den entsprechenden Elementen nach Fig. 2 ähnlich sind.

Ein Unterschied besteht jedoch darin, dass einerseits der Frequenzumwandler DV durch die Signale p gesteuert und der zweite Eingang des Mischers XK mit dem Signal Sm beaufschlagt wird, wobei der Umwandler DV vorzugswiese als Frequenzteiler mit einem Teilungsfaktor n arbeitet.

Der Frequenzsynthetisierer funktioniert folgendermassen:

Die Frequenzen f1, f2, f3, f4 der Signale Sa, Sb, Sc bzw. Sd sind vorzugsweise so gewählt, dass die Beziehungen

$$f4 - f3 = f3 - f2 = f2 - f1 = fe$$

gelten. Die Umschalteinrichtung US wird von den Signalen g derart gesteuert, dass das Signal x wahlweise eines der Signale Sa, Sb, Sc oder Sd ist oder mindestens eine der Frequenzen f1, f2, f3 oder f4 aufweist. Entsprechendes gilt für das Signal y.

Die Frequenz fn des Nutzsignals Sn (Fig. 1) ist somit, wenn die Elemente FA und MB Frequenzvervielfacher sind, die mit den Faktoren a bzw. b multiplizieren

$$fn = b \bullet (fi + a \bullet fj) \text{ mit } i = 1,2,3,4 \text{ und } j = 1, 2, 3, 4 \,.$$

Ohne die Elemente TA, T und K gelten für die Frequenzen f1, f2, f3, f4 folgende Beziehungen

$$fh = n \bullet fr + fm \text{ (Fig.3) und}$$
$$fk = nk \bullet fv + fh \text{ (Fig.2) mit } k = 1, 2, 3, 4$$

worin fr, fv, fh und fm die Frequenzen der Signale Sr, Sv, Sh und Sm sind. Daraus ergibt sich

$$fn = b \bullet (nk \bullet fv + n \bullet fr + fm) + b \bullet a \bullet (nj \bullet fv + n \bullet fr + fm)$$

mit

$$k = \quad 1,2,3,4$$
$$j = \quad 1,2,3,4$$
$$n = \quad 1,2,3,4$$

Es wurde somit ein Frequenzsynthetisierer realisiert der eine Anzahl $4^3 = 64$ verschiedener, beispielsweise äquidistanter Frequenzwerte ergibt. Bekannte Synthetisierer, die mit derselben Umschalteinrichtung US arbeiten, ergeben vergleichsweise nur eine Anzahl $4^2 = 16$ Frequenzwerte.

Durch die Frequenz-Umschaltung über den Phasenregelkreis PLL (Fig. 3), der relativ langsam arbeitet, wird allerdings die Umschaltgeschwindigkeit bei den entsprechenden Frequenzumschaltungen kleiner, als wen man eine erweiterte Umschalteinrichtung der in Fig. 1 dargestellter Art gewählt hätte. Dieser Umstand ist für viele Anwendungen nicht hinderlich, insbesondere bei Wahl einer geeigneten Reihenfolge bei der Umschaltung der gewünschten Frequenzen. Der Frequenzsynthetisierer erweist sich trotzdem als vorteilhaft im Hinblick auf eine weniger komplexe Umschalteinrichtung US, die daher preisgünstiger ist und eine höhere Zuverlässigkeit (MTBF) aufweist. Im folgenden wird ein numerisches Beispiel für äquidistante Frequenzen angegeben. Mit

fm = 1000 MHz     fr = 1 MHz

und n = 5, 6, 7 oder 8 beliebig wählbar (Fig. 3) ergibt sich nach der Formel

$$fh = n \bullet fr + fm$$

fh = 1005, 1006, 1007 oder 1008 MHz.

Für fv = 20 $\bullet$ fr = 20 MHz

und n1 = 1, n2 = 2, n3 = 3 und n4 = 4

ergeben sich nach den Formeln fk = nk $\bullet$ fv + fh die Werte nach folgender

## Tabelle I

| fh | 1005 | 1006 | 1007 | 1008 |
|----|------|------|------|------|
| f1 | 1025 | 1026 | 1027 | 1028 |
| f2 | 1045 | 1046 | 1047 | 1048 |
| f3 | 1065 | 1066 | 1067 | 1068 |
| f4 | 1085 | 1086 | 1087 | 1088 |

Der Frequenzumwandler FA sei beispielsweise ein Vervielfacher, der mit dem Faktor a = 4 multipliziert. Falls das Element MB entfällt, ergeben sich daraus für die Frequenz fz mit fh = 1005, 1006, 1007 oder 1008 MHz die Werte der Tabellen II, III, IV bzw. V wie folgt:

### Tabelle II

|  | 4·f1 | 4·f2 | 4·f3 | 4·f4 |
|---|---|---|---|---|
| f1 | 5125 | 5205 | 5285 | 5365 |
| f2 | 5145 | 5225 | 5305 | 5385 |
| f3 | 5165 | 5245 | 5325 | 5405 |
| f4 | 5185 | 5265 | 5345 | 5425 |

### Tabelle III

|  | 4·f1 | 4·f2 | 4·f3 | 4·f4 |
|---|---|---|---|---|
| f1 | 5130 | 5210 | 5290 | 5370 |
| f2 | 5150 | 5230 | 5310 | 5390 |
| f3 | 5170 | 5250 | 5330 | 5410 |
| f4 | 5190 | 5270 | 5350 | 5430 |

### Tabelle IV

|  | 4·f1 | 4·f2 | 4·f3 | 4·f4 |
|---|---|---|---|---|
| f1 | 5135 | 5215 | 5295 | 5375 |
| f2 | 5155 | 5235 | 5315 | 5395 |
| f3 | 5175 | 5255 | 5335 | 5415 |
| f4 | 5195 | 5275 | 5355 | 5435 |

### Tabelle V

|  | 4·f1 | 4·f2 | 4·f3 | 4·f4 |
|---|---|---|---|---|
| f1 | 5140 | 5220 | 5300 | 5380 |
| f2 | 5160 | 5240 | 5320 | 5400 |
| f3 | 5180 | 5260 | 5340 | 5420 |
| f4 | 5200 | 5280 | 5360 | 5440 |

Durch ein geeignetes Umschalten des Frequenzsynthetisierers wahlweise gemäss einer der Tabellen II bis V können die Frequenzen $f_z$ = 5125, 5130, 5135, 5140, 5145, ..... 5440 MHz erzeugt werden, die eine regelmässige Reihenfolge darstellen.

Die Frequenz $f_z$ nach den Tabellen II bis V kann gegebenenfalls mit Hilfe des Frequenzumwandlers MB nochmals mit einem Faktor b multipliziert bzw. dividiert werden. Die Umschaltzeit der Umschalteinrichtung US kann beispielsweise $1\mu s$ betragen. Bei einer Schleifenbandbreite des Phasenregelkreises PLL von 100 kHz wird die Schaltzeit zum Beispiel $10\mu s$. Wird somit zwischen Frequenzen umgeschaltet, die von derselben Frequenz $f_h$ abgeleitet sind, ergibt sich eine Umschaltzeit von $t_1 = 1\mu s$; falls $f_h$ gewechselt wird, ergibt sich eine Umschaltzeit von $t_2 = 10\mu s$.

In weiterer Ausgestaltung der Erfindung können die Frequenzumwandler T und TA, TB, ..... mit Hilfe von externen Signalen p' bzw. pa,..... steuerbar sein, um insbesondere die Anzahl der umschaltbaren Ausgangssignale zu erhöhen.

Durch folgende Massnahmen kann der Frequenzsynthetisierer nach Fig. 1 vereinfacht werden:

Der Frequenzumwandler DR kann entfallen, indem die Eingänge der Schaltungen PLA, PLB, PLC und PLD gemeinsam mit dem Ausgangssignal sr des Teilers D beaufschlagt werden; in einem weiteren Fall können die Elemente TA und T (Fig. 2 bzw. 3)ebenso entfallen.

Schliesslich kann der Eingang der Schaltung PLL (Fig. 1) bzw. der Eingang des fakultiven Frequenzumwandlers K mit dem Ausgangssignal S'm eines weiteren Oszillators OSZ anstelle des Signals Sm beaufschlagt werden.

**Patentansprüche**

1. Frequenzsynthetisierer mit einer Umschalteinrichtung (US), die mindestens einen Eingang aufweist, der mit dem Ausgang einer PLL-Schaltung verbunden ist und die zwei Ausgangssignale (x, y) liefert, von denen eines (y) dem Eingang eines Mischers (X) und das andere (x) über einen Frequenzumwandler (FA) dem andern Eingang dieses Mischers (X) zugeführt wird, **dadurch gekennzeichnet**, dass der Frequenzsynthetisierer eine steuerbare PLL-Schaltung (PLL) aufweist, die einen Frequenzumwandler (DV) umfasst, dessen Faktor mit Hilfe von externen Signalen (p) wählbar ist, dass zwischen dem Ausgang dieser steuerbaren PLL-Schaltung und je einem Eingang der Umschalteinrichtung (US) mindestens zwei weitere PLL-Schaltungen (PLA, PLB) eingefügt sind, deren Mischereingänge mit dem Ausgangssignal (Sh) der steuerbaren PLL-Schaltung (PLL) beaufschlagt sind, und dass dem Referenzsignaleingang und dem Mischereingang der steuerbaren PLL-Schaltung sowie den Referenzsignaleingängen der weiteren PLL-Schaltungen (PLA, PLB) je ein Oszillatorsignal (Sr, Sm bzw. Sv) zugeführt wird.

2. Frequenzsynthetisierer nach Anspruch 1, **dadurch gekennzeichnet**, dass in mindestens einer der PLL-Schaltungen zwischen dem Ausgang eines spannungsgesteuerten Oszillators (VCOA, VCO) und dem anderen Eingang des in der PLL-Schaltung vorhandenen Mischers (XA, XK) ein Frequenzumwandler (TA, T) eingefügt ist.

**Claims**

1. A frequency synthesizer with a switchover device (US), which has at least one input, which is connected to the output of a PLL circuit and which delivers two output signals (x,y), one (y) of which is supplied to the input of a mixer (X) and the other (x) of which is supplied by way of a frequency converter (FA) to the other input of this mixer (X), characterised in that the frequency synthesizer has a controllable PLL circuit (PLL), which includes a frequency converter (DV), the coefficient of which is selectable with the aid of external signals (p), in that between the output of this controllable PLL circuit and the inputs of the switchover device (US), there are inserted at least two further PLL circuits (PLA, PLB), the mixing inputs of which are acted upon with the output signal (Sh) of the controllable PLL circuit (PLL), and in that an oscillator signal (Sr, Sm or Sv) is supplied to the reference signal input and the mixer input of the controllable PLL circuit, as well as the reference signal inputs of the further PLL circuits (PLA, PLB).

2. A frequency synthesizer according to claim 1, characterised in that in at least one of the PLL circuits between the output of a voltage-controlled oscillator (VCOA, VCO) and the other input of the mixer (XA, XK), present in the PLL circuit, there is inserted a frequency converter (TA, T).

**Revendications**

1. Synthétiseur de fréquence comportant un dispositif de commutation (US), qui possède au moins une entrée raccordée à la sortie d'un circuit formant boucle à verrouillage de phase et délivrant les deux signaux de sortie (x, y), dont l'un (y) est envoyé à l'entrée d'un mélangeur (X) et dont l'autre (x) est envoyé, par l'intermédiaire d'un convertisseur de fréquence (FA), à l'autre entrée de ce mélangeur (X), caractérisé par le fait que le synthétiseur de fréquence possède un circuit commandable formant boucle à verrouillage de phase (PLL), qui comprend un convertisseur de fréquence (DV), dont le facteur peut être sélectioné au moyen de signaux externes (p), qu'entre la sortie de ce circuit commandable à boucle à verrouillage de phase et respectivement une entrée du dispositif de commutation (US) sont insérés au moins deux circuits à boucles à verrouillage de phase (PLA, PLB), dont les entrées mélangeuses sont chargées par le signal de sortie (Sh) du circuit commandable à boucle à verrouillage de phase (PLL), et que des signaux respectifs (Sr, Sm ou Sv) d'oscillateurs sont envoyés à l'entrée du signal de référence et à l'entrée mélangeuse du circuit commandable à boucle à verrouillage de phase ainsi qu'aux entrées des signaux de référence des autres circuits à boucle à verrouillage de phase (PLA, PLB).

2. Synthétiseur de fréquence suivant la revendication 1, caractérisé par le fait qu'un convertisseur de fréquence (TA, T) est inséré dans au moins l'un des circuits à boucles à verrouillage de phase entre la sortie d'un oscillateur commandé par la tension (VCOA, VCO) et l'autre entrée du mélangeur (XA, XK) présent dans le circuit à boucle à verrouillage de phase.

**FIG. 1**

FIG. 2

FIG. 3